# EUROPÄISCHE PATENTSCHRIFT

(11) **EP 1 016 137 B1**
(45) Veröffentlichungstag und Bekanntmachung des Hinweises auf die Patenterteilung: **04.12.2002**
(21) Anmeldenummer: 98948759.0
(22) Anmeldetag: 11.08.1998
(51) Int. Cl.: H01L 23/051, H01L 23/049, H01L 23/24

(54) **GEHÄUSE ZUR AUFNAHME EINES PLANAREN LEISTUNGSTRANSISTORS**
HOUSING FOR RECEIVING A PLANAR POWER TRANSISTOR
BOITIER SERVANT A LOGER UN TRANSISTOR DE PUISSANCE PLANAIRE

(30) Priorität: 06.09.1997 DE 19739083
(43) Veröffentlichungstag der Anmeldung: 05.07.2000
(73) Patentinhaber: ROBERT BOSCH GMBH, 70442 Stuttgart (DE)
(72) Erfinder: TOPP, Rainer, D-72768 Reutlingen (DE)
(86) Internationale Anmeldenummer: DE9802295
(87) Internationale Veröffentlichungsnummer: WO99013508

(56) Entgegenhaltungen:
- EP-A- 0 122 431
- EP-A- 0 516 416
- EP-A- 0 694 964

## Beschreibung

Die Erfindung betrifft ein Gehäuse zur Aufnahme eines planaren Leistungstransistors mit den im Oberbegriff des Anspruchs 1 genannten Merkmalen.

### Stand der Technik

Es ist bekannt, Leistungstransistoren in Gehäusen hermetisch abgedichtet anzuordnen. Planare Leistungstransistoren besitzen einen Chip, bei dem die funktionell dotierten Zonen mittels Metallisierungen kontaktierbar sind. Die Metallisierungen sind mit elektrischen Anschlüssen verbunden, die zur Einbindung des Leistungstransistors in eine Schaltungsanordnung aus dem Gehäuse herausgeführt sind. Leistungstransistoren weisen drei Anschlüsse auf, die dem Verbinden mit einem positiven Spannungspotential, dem Verbinden mit einem negativen Spannungspotential und als Steueranschluß dienen.

Aus der DE 43 27 309 A1 ist bekannt, einen Leistungstransistor in einer Leistungstransistorpackung anzuordnen, wobei der Leistungstransistor in einem gegossenen, elektrisch isolierenden Kunststoffgehäuse angeordnet ist. Hierbei ist nachteilig, daß eine optimale Abfuhr von im Leistungstransistor erzeugter Verlustleistungswärme über das Kunststoffgehäuse beziehungsweise die relativ gering dimensionierten elektrischen Anschlüsse erfolgen muß. Der Abfuhr der Verlustleistungswärme sind somit erhebliche Grenzen gesetzt. Die Patentanmeldungen EP-A-0 122 431 und EP-A-0 516 416 beschreiben jemeils Gehäuse zur Aufnahme von Halbleiterbauelementen.

### Vorteile der Erfindung

Das erfindungsgemäße Gehäuse mit den im Anspruch 1 genannten Merkmalen bietet demgegenüber den Vorteil, daß eine optimale Wärmeabfuhr einer von einem Chip des Leistungstransistors erzeugten Verlustleistungswärme möglich ist. Dadurch, daß das Gehäuse, zumindest bereichsweise, von wenigstens einem der elektrischen Anschlüsse gebildet wird, ist vorteilhaft möglich, eine großflächige Kontaktierung bereitzustellen, über die eine Wärmeabfuhr erfolgen kann. Darüber hinaus kann der wenigstens eine, ein Teil des Gehäuses bildende, elektrische Anschluß gleichzeitig für eine Montage des gesamten Leistungstransistors vorteilhaft genutzt werden. So kann über den elektrischen Anschluß eine mechanische und elektrisch leitende Verbindung des Leistungstransistors mit einem ein positives und/oder negatives Spannungspotential führenden Bauelement erfolgen. Insbesondere ist bevorzugt, wenn über den elektrischen Anschluß des Leistungstransistors eine Einpreßmontage des Leistungstransistors in ein Bauelement möglich ist.

Weitere vorteilhafte Ausgestaltungen der Erfindung ergeben sich aus den übrigen, in den Unteransprüchen genannten Merkmalen.

### Zeichnung

Die Erfindung wird nachfolgend in einem Ausführungsbeispiel anhand der zugehörigen Zeichnung, die schematisch eine Schnittansicht durch ein in einem Gehäuse angeordneten Leistungstransistor zeigt, näher erläutert.

### Beschreibung des Ausführungsbeispiels

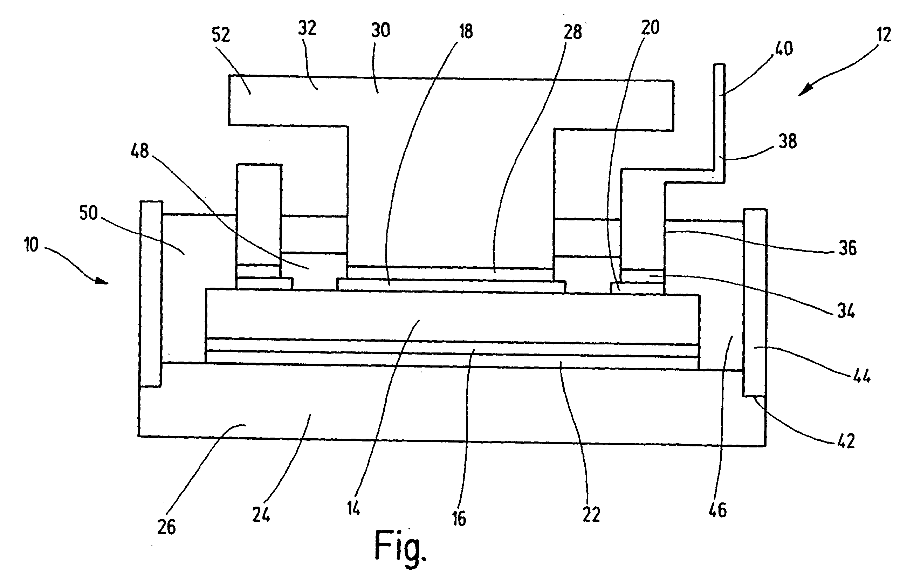

In der Figur ist in einer schematischen Schnittdarstellung ein in einem Gehäuse 10 angeordneter Leistungstransistor 12 dargestellt. Der Leistungstransistor 12 weist einen planaren Chip 14 auf, der - in hier nicht näher zu betrachtender Weise - strukturiert ist. Der Chip 14 besitzt eine Rückseitenmetallisierung 16, eine erste Vorderseitenmetallisierung 18 und eine zweite Vorderseitenmetallisierung 20. Die Metallisierungen 16, 18 und 20 dienen dem elektrischen Anschluß der in dem Chip 14 strukturierten Bereiche, also beispielsweise dem Kollektor, dem Emitter und der Basis beziehungsweise dem Drain, der Source und dem Gate. Die Metallisierungen 16 und 18 sind mit den Leistungsanschlüssen, also einem positiven Spannungspotential und/oder einem negativen Spannungspotential verbunden. Die Metallisierung 20 dient dem Steueranschluß, also der Basis beziehungsweise dem Gate.

Die Rückseitenmetallisierung 16 ist über ein Weichlot 22 auf einem Sockel 24 aufgebracht. Der Sockel 24 besteht aus einem elektrisch leitenden Material und bildet einen elektrischen Anschluß 26 der Metallisierung 16 des Chips 14.

Die Metallisierung 18 ist über ein Weichlot 28 mit einem Kopfträger 30 verbunden. Der Kopfträger 30 besteht ebenfalls aus einem elektrisch leitfähigen Material und bildet einen elektrischen Anschluß 32 der Metallisierung 18 des Chips 14.

Schließlich ist die Metallisierung 20 über ein Weichlot 34 mit einem Ringelement 36 verbunden, das eine, radial zu einer vertikal durch das Gehäuse 10 verlaufenden gedachten Linie, abkragende Anschlußfahne 38 besitzt. Das Ringelement 36 und die Anschlußfahne 38 sind aus einem elektrisch leitfähigen Material und bilden einen elektrischen Anschluß 40 der Metallisierung 20 des Chips 14.

Der Sockel 24 bildet an seinem Außenumfang eine Ringnut 42 aus, die der Aufnahme einer Hülse 44 dient. Die Hülse 44 ist in die Ringnut 42 beispielsweise eingeklebt, eingelötet oder auf andere geeignete Weise befestigt. Die Hülse 44 kann - je nach Einbindung des Leistungstransistors 12 in eine Schaltungsanordnung - aus einem elektrisch leitfähigen Material oder aus einem elektrisch isolierenden Material bestehen. Durch die Anordnung der Hülse 44 wird ein Innenraum 46 ausgebildet, in dem der Chip 14 mit seinen Metallisierungen 16, 18 beziehungsweise 20 angeordnet ist. Ein Zwischenraum zwischen den Metallisierungen 18 und 20 ist mit einem Isolierlack 48 ausgefüllt. Der verbleibende Innenraum 46 wird mit einer Vergußmasse 50 aufgefüllt, die den Chip 14 hermetisch abdichtet.

Aus dem Gehäuse 10, das aus dem Sockel 24, der Hülse 44 sowie der Vergußmasse 50 besteht, ragen - in der gezeigten Ansicht nach oben - der Kopfträger 30 und das Ringelement 36 mit seiner Anschlußfahne 38 heraus. Somit sind der Kopf träger 30 sowie die Anschlußfahne 38 als elektrische Anschlüsse 32 beziehungsweise 40 kontaktierbar. Der Sockel 24 bildet quasi den Boden des Gehäuses 10 und ist als elektrischer Anschluß 26 ebenfalls kontaktierbar. Der Kopfträger (30) bildet einen Deckel des Gehäuses 10.

Der Sockel 24 bildet den gesamten Boden des Gehäuses 10 aus, so daß ein relativ großflächiger elektrischer Anschluß 26 zur Verfügung steht. Der Kopfträger 30 bildet einen Schirm 52 aus, so daß für den elektrischen Anschluß 32 ebenfalls eine große Kontaktfläche zur Verfügung steht. Eine elektrische Kontaktierung der elektrischen Anschlüsse 26 und 32 kann beispielsweise durch Verbinden mit einem das benötigte Spannungspotential aufweisenden Bauelement, beispielsweise eine metallische Platte, erfolgen. Die Kontaktierung kann beispielsweise über eine Lötverbindung erfolgen. Durch das großflächige Aufliegen der elektrischen Anschlüsse 26 beziehungsweise 32 an den jeweiligen die Spannungsversorgung übernehmenden Platten wird neben einer hohen Stromtragfähigkeit der elektrischen Anschlüsse 26 und 32 eine optimale thermische Kontaktierung des Chips 14 sichergestellt. Über die im Verhältnis relativ voluminösen Sockel 24 beziehungsweise Kopfträger 30 erfolgt eine optimale Abfuhr einer Verlustleistungswärme des Chips 14. Ferner wird durch das relativ voluminöse Ausbilden des Sockels 24 und des Kopfträgers 30 eine im Verhältnis große Masse bereitgestellt, die neben der guten Abführung der Verlustwärmeleistung einen dynamischen thermischen Schutz des Chips 14 vor äußeren Wärmequellen bietet. Die Abfuhr der Verlustleistungswärme und der Schutz vor äußerer Wärmeenergie erfolgt beidseitig des Chips 14, so daß ein besonders optimaler Schutz gegeben ist.

Dadurch, daß der Chip 14 praktisch durch den Sockel 24 und den Kopfträger 30 eingekapselt ist, ist der Leistungstransistor 12 auch für einen sehr robusten Betrieb, wie er beispielsweise in Schaltungsanordnungen in Kraftfahrzeugen gegeben ist, geeignet.

Bis auf die radial auskragende Anschlußfahne 38 sind sämtliche Teile des Leistungstransistors 12 rotationssymmetrisch ausgebildet, so daß in einfacher Weise eine Massenfertigung erfolgen kann, da eine spezielle Ausrichtung des Chips 14 zu dem Sockel 24 beziehungsweise dem Kopfträger 30 sowie dem Ringelement 36 und der Hülse 44 nicht erfolgen muß.

Nach einem nicht gezeigten Ausführungsbeispiel kann vorgesehen sein, den Sockel 24 und/oder den Kopfträger 30, insbesondere dessen Schirm 52, radial über die Anschlußfahne 38 hinaus zu vergrößern. Somit kann neben einer weiter optimierten thermischen und elektrischen Anschlußmöglichkeit des Chips 14 der gesamte Leistungstransistor 12 mit seinem Gehäuse 10 für eine sogenannte Einpreßmontage in eine entsprechende Ausnehmung eines metallischen Bauelementes ausgelegt sein. Somit wird ein Einsatz auch bei extremen Temperatur- und Strombelastungen möglich.

## Patentansprüche

1. Gehäuse zur Aufnahme eines planaren Leistungstransistors, wobei ein Chip des Leistungstransistors innerhalb des Gehäuses hermetisch abgedichtet angeordnet ist und Metallisierungen des Chips über elektrische Anschlüsse aus dem Gehäuse herausgeführt sind, wobei das Gehäuse (10) zumindest bereichsweise von wenigstens einem der elektrischen Anschlüsse (26, 32) gebildet wird, wobei einer der elektrischen Anschlüsse (26) von einem Sockel (24) gebildet ist, der gleichzeitig einen Boden des Gehäuses (10) bildet, wobei ein weiterer der elektrischen Anschlüsse (32) von einem Kopfträger (30) gebildet ist, der gleichzeitig einen Deckel des Gehäuses (10) bildet, wobei der Chip (14) von einer sich an dem Sockel (24) abstützenden Hülse (44) umgriffen ist, wobei ein Innenraum (46) der Hülse (44) mit einer den Chip (14) hermetisch abdichtenden Vergußmasse (50) ausgefüllt ist, **dadurch gekennzeichnet, daß** sowohl der Kopfträger (30) als auch ein Ringelement (36), das den Kopfträger (30) unterhalb eines Schirmes (52) zwischen der Außenseite des Kopfträgers und der Hülse umgreift, über ein Lot (28 bzw. 34) mit einer Metallisierung (18 bzw. 20) des Chips 14 elektrisch leitend verbunden sind, wobei der Zwischenraum auf dem Chip zwischen den Metallisierungen (18, 20) mit einem Isolierlack (48) ausgefüllt ist, wobei der Isolierlack mit der Vergußmasse (50) bedeckt ist, wobei der Kopfträger den Schirm (52) ausbildet, der zu der Hülse (44) beabstandet ist, wobei der sich ergebende Abstand der Herausfuhrung einer Anschlußfahne (38) dient, die von dem Ringelement (36) abkragt und die einen Steueranschluß (40) des Leistungstransistors (12) bildet.

2. Halbleiterbauelement mit Gehäuse mit darin hermetisch abgedichtet angeordnetem Chip eines planaren Leistungstransistors, bei dem Metallisierungen des Chips über elektrische Anschlüsse aus dem Gehäuse herausgeführt sind, wobei das Gehäuse (10) zumindest bereichsweise von wenigstens einem der elektrischen Anschlüsse (26, 32) gebildet wird, wobei einer der elektrischen Anschlüsse (26) von einem Sockel (24) gebildet ist, der gleichzeitig einen Boden des Gehäuses (10) bildet, wobei ein weiterer der elektrischen Anschlüsse (32) von einem Kopfträger (30) gebildet ist, der gleichzeitig einen Deckel des Gehäuses (10) bildet, wobei der Chip (14) von einer sich an dem Sockel (24) abstützenden Hülse (44) umgriffen ist, wobei ein Innenraum (46) der Hülse (44) mit einer den Chip (14) hermetisch abdichtenden Vergußmasse (50) ausgefüllt ist, **dadurch gekennzeichnet, daß** sowohl der Kopfträger (30) als auch ein Ringelement (36), das den Kopfträger (30) unterhalb des Schirmes (52) zwischen der Außenseite des Kopfträgers und der Hülse umgreift, über ein Lot (28 bzw. 34) mit einer Metallisierung (18 bzw. 20) des Chips 14 elektrisch leitend verbunden sind, wobei der Zwischenraum auf dem Chip zwischen den Metallisierungen (18, 20) mit einem Isolierlack (48) ausgefüllt ist, wobei der Isolierlack mit der Vergußmasse (50) bedeckt ist, wobei der Kopf träger einen Schirm (52) ausbildet, der zu der Hülse (44) beabstandet ist, wobei der sich ergebende Abstand der Herausführung einer Anschlußfahne (38) dient, die von dem Ringelement (36) abkragt und die einen Steueranschluß (40) des Leistungstransistors (12) bildet.

3. Gehäuse bzw. Halbleiterbauelement nach Anspruch 1 bzw. 2, **dadurch gekennzeichnet, daß** der Sockel (24) mit einer Metallisierung (16) des Chips (14) elektrisch leitend verbunden ist.

4. Gehäuse bzw. Halbleiterbauelement nach einem der vorhergehenden Ansprüche, **dadurch gekennzeichnet, daß** mit Ausnahme der Anschlußfahne (38) sämtliche Teile des Leistungstransistors (12) beziehungsweise dessen Gehäuse (10) rotationssymmetrisch ausgebildet sind.

5. Gehäuse bzw. Halbleiterbauelement nach einem der vorhergehenden Ansprüche, **dadurch gekennzeichnet, daß** der Sockel (24) und/oder der Kopfträger (30) die Anschlußfahne (38) überragt.

6. Gehäuse bzw. Halbleiterbauelement nach einem der vorhergehenden Ansprüche, **dadurch gekennzeichnet, daß** der Leistungstransistor (12) über den Sockel (24) und/oder den Kopfträger (30) mit einem ein positives beziehungsweise negatives Spannungspotential aufweisendes Bauelement über eine Einpreßmontage kontaktierbar ist.

## Claims

1. Housing for holding a planar power transistor, with a chip of the power transistor being arranged such that it is hermetically sealed within the housing, and metallizations of the chip being passed out of the housing via electrical connections, with the housing (10) being formed, at least in places, from at least one of the electrical connections (26, 32), with one of the electrical connections (26) being formed by a cap (24) which at the same time forms a base of the housing (10), with a further one of the electrical connections (32) being formed by a head support (30) which at the same time forms a cover of the housing (10), with the chip (14) being surrounded by a sleeve (44) which is supported on the cap (24), with an internal area (46) of the sleeve (44) being filled with an encapsulation compound (50) which hermetically seals the chip (14), **characterized in that** both the head support (30) and a ring element (36), which engages around the head support (30) under a screen (52) between the outside of the head support and the sleeve, being electrically conductively connected via solder (28 or 34, respectively) to a metallization (18 or 20 respectively) of the chip (14), with the space on the chip between the metallizations (18, 20) being filled with an insulating varnish (48), with the insulating varnish being covered with encapsulation compound (50), with the head support forming the screen (52) which is at a distance from the sleeve (44), and with the resultant distance being used to pass out a connecting lug (38), which projects from the ring element (36) and forms a control connection (40) for the power transistor (12).

2. Semiconductor component having a housing with a chip, which is arranged in a hermetically sealed manner in it, on a planar power transistor, in which metallizations of the chip are passed out of the housing via electrical connections, with the housing (10) being formed at least in places by at least one of the electrical connections (26, 32), with one of the electrical connections (26) being formed by a cap (24) which at the same time forms a base of the housing (10), with a further one of the electrical connections (32) being formed by a head support (30) which at the same time forms a cover of the housing (10), with the chip (14) being surrounded by a sleeve (44) which is supported on the cap (24), with an internal area (46) of the sleeve (44) being filled with an encapsulation compound (50) which hermetically seals the chip (14), **characterized in that** both the head support (30) and a ring element (36), which engages around the head support (30) under the screen (52) between the outside of the head support and the sleeve, being electrically conductively connected via solder (28 or 34, respectively) to a metallization (18 or 20 respectively) of the chip (14), with the space on the chip between the metallizations (18, 20) being filled with an insulating varnish (48), with the insulating varnish being covered with encapsulation compound (50), with the head support forming a screen (52) which is at a distance from the sleeve (44), and with the resultant distance being used to pass out a connecting lug (38), which projects from the ring element (36) and forms a control connection (40) for the power transistor (12).

3. Housing or semiconductor component according to Claim 1 or 2, **characterized in that** the cap (24) is electrically conductively connected to metallization (16) on the chip (14).

4. Housing or semiconductor component according to one of the preceding claims, **characterized in that**, with the exception of the connecting lug (38), all the parts of the power transistor (12) and of its housing (10) are designed to be rotationally symmetrical.

5. Housing or semiconductor component according to one of the preceding claims, **characterized in that** the cap (24) and/or the head support (30) overhang/overhangs the connecting lug (38).

6. Housing or semiconductor component according to one of the preceding claims, **characterized in that** the power transistor (12) can make contact via the cap (24) and/or via the head support (30) with a component which is at a positive or negative voltage potential, by push-in mounting.

## Revendications

1. Boîtier pour recevoir un transistor de puissance planaire, dans lequel, une puce du transistor de puissance est logée de manière hermétique étanche dans le boîtier et des métallisations de la puce sortent du boîtier par des branchements électriques, le boîtier (10) étant formé au moins par zones par des branchements électriques (26, 32), l'un des branchements électriques (26) étant formé par un socle (24) qui constitue en même temps le fond du boîtier (10), un autre branchement électrique (32) étant formé par un support de tête (30) constituant en même temps un couvercle pour le boîtier (10), tandis que la puce (14) est entourée par un manchon (44) s'appuyant contre le socle (24), le volume intérieur (46) du manchon (44) étant rempli d'une masse coulée (50) qui assure hermétiquement l'étanchéité de la puce (14),
**caractérisé en ce qu'**
à la fois le support de tête (30) et un élément annulaire (36) qui entoure le support de tête (30) en dessous de l'écran (52) entre le côté extérieur du support de tête et le manchon, sont reliés électriquement par une soudure (28, 34) à une métallisation (18, 20) de la puce (14), l'intervalle de la puce entre les métallisations (18, 20) est rempli de vernis isolant (48), le vernis isolant est recouvert d'une masse coulée (50), le support de tête forme l'écran (52) distant du manchon (44), la distance résultante servant à faire sortir une patte de branchement (38) qui vient en saillie de l'élément annulaire (36) et forme un branchement de commande (40) du transistor de puissance (12).

2. Composant semi-conducteur comprenant un boîtier logeant une puce hermétiquement étanche d'un transistor de puissance planaire, selon lequel des métallisations de la puce sortent du boîtier par des branchements électriques,
le boîtier (10) étant formé au moins en partie par l'un des branchements électriques (26, 32), l'un des branchements électriques (26) étant formé par un socle (24) qui constitue en même temps le fond du boîtier (10), un autre des branchements électriques (32) étant formé par un support de tête (30) constituant en même temps un couvercle pour le boîtier (10), la puce (14) étant entourée par un manchon (44) s'appuyant contre le socle (24), le volume intérieur (46) du manchon (44) étant rempli d'une masse coulée (50) fermant hermétiquement la puce (14),
**caractérisé en ce qu'**
à la fois le support de tête (30) et un élément annulaire (36) qui entoure le support de tête (30) en dessous du blindage (52) entre le côté extérieur du support de tête et le manchon, sont reliés électriquement par une soudure (28, 34) à une métallisation (18, 20) de la puce (14),
l'intervalle sur la puce entre les métallisations (18, 20) étant rempli d'un vernis isolant (48), le vernis isolant étant couvert de la masse coulée (50), le support de tête formant un blindage (52) distant de la douille (44), la distance qui en résulte servant à faire sortir une patte de branchement (38) qui vient en saillie de l'élément annulaire (36) et forme un branchement de commande (40) du transistor de puissance (12).

3. Boîtier ou composant semi-conducteur selon la revendication 1 ou 2,
**caractérisé en ce que**
le socle (24) est relié électriquement à une métallisation (16) de la puce (14).

4. Boîtier ou composant semi-conducteur selon l'une quelconque des revendications précédentes,
**caractérisé en ce qu'**
à l'exception de la patte de branchement (38), toutes les pièces du transistor de puissance (12) ou son boîtier (10) sont symétriques en rotation.

5. Boîtier ou composant semi-conducteur selon l'une quelconque des revendications précédentes,
**caractérisé en ce que**
la patte de branchement (38) dépasse du socle (24) et/ou du support de tête (30).

6. Boîtier ou composant semi-conducteur selon l'une quelconque des revendications précédentes,
**caractérisé en ce que**
le transistor de puissance (12) peut être mis en contact par le socle (24) et/ou le support de tête (30) à un composant fournissant un potentiel positif ou négatif, cette mise en contact se faisant par un montage pressé.
